# EUROPEAN PATENT APPLICATION

(11) **EP 4 592 080 A1**
(43) Date of publication of application: **30.07.2025**
(21) Application number: 24218661.7
(22) Date of filing: 10.12.2024
(51) Int. Cl.: B41J 2/14

(54) **PIEZOELECTRIC ACTUATOR, LIQUID DISCHARGE HEAD, AND LIQUID DISCHARGE APPARATUS**

(30) Priority: 29.01.2024 JP 2024010926
(71) Applicant: Ricoh Company, Ltd., Tokyo 143-8555 (JP)
(72) Inventor: MIWA, Keishi, Tokyo, 143-8555 (JP)
(74) Representative: J A Kemp LLP

(57) **Abstract**

A piezoelectric actuator (39) includes a base (22), a diaphragm (33), and a piezoelectric element (40). The base has a slot (41, 41a) and a partition wall (48) partitioning the slot. The diaphragm is bonded to the base in a bonding direction. The diaphragm has a first face and a through hole (55). The diaphragm is disposed on the partition wall and covers the slot. The through hole penetrates the diaphragm in the bonding direction. The through hole is positioned at a position opposed to the partition wall in a transverse direction intersecting the bonding direction, and extends along at least a portion of the slot in a longitudinal direction intersecting the bonding direction and the transverse direction. The piezoelectric element is disposed on a second face of the diaphragm opposite to the first face of the diaphragm.

## Description

### BACKGROUND

### Technical Field

Embodiments of the present disclosure relate to a piezoelectric actuator, a liquid discharge head, and a liquid discharge apparatus.

### Related Art

As a liquid discharge head mounted on a liquid discharge apparatus, a liquid discharge head is known that discharges liquid using a piezoelectric actuator including a piezoelectric element.

Typically, in the liquid discharge head as described above, a part of a wall of a liquid chamber serves as a diaphragm, and the diaphragm includes a piezoelectric element. When the piezoelectric element is energized and deformed, the diaphragm vibrates in accordance with the deformation of the piezoelectric element. By so doing, the pressure in the liquid chamber changes, and the liquid is discharged from the liquid chamber.

Japanese Unexamined Patent Application Publication No. 2016-165816 discloses a configuration in which recesses are formed at positions other than a region in which liquid chambers of a diaphragm are formed and anchors in which lower electrodes enter the recesses are disposed, to prevent the lower electrodes formed on the diaphragm from peeling off from the diaphragm.

Residual stress may be generated in the diaphragm after the diaphragm is molded. If the diaphragm has a residual stress, when the diaphragm is deformed during liquid discharge, stress is generated due to the deformation of the diaphragm in addition to the residual stress. Accordingly, a large stress acts on the diaphragm, which may cause the diaphragm to be damaged.

Further, when the diaphragm is warped due to the residual stress, the warping is corrected when the diaphragm is bonded to another member. Accordingly, a load is applied to, for example, the diaphragm. As a result, the diaphragm may be damaged. In addition, when the diaphragm is conveyed or sucked in the manufacturing process, a conveyance failure and a suction failure may occur due to the warping of the diaphragm.

### SUMMARY

In light of the above-described problems, a purpose of the present disclosure is to reduce the residual stress of a diaphragm.

To solve the above problem, a piezoelectric actuator includes a base having a slot and a partition wall that partitions the slot, a diaphragm disposed on the partition wall to cover the slot, and a piezoelectric element disposed on a side of the diaphragm opposite a side of the diaphragm bonded to the base. The diaphragm has a recess penetrating the diaphragm on the partition wall arranged along at least a portion extending in the longitudinal direction of the slot.

According to embodiments of the present disclosure, the residual stress of the diaphragm can be reduced.

### BRIEF DESCRIPTION OF THE SEVERAL VIEWS OF THE DRAWINGS

A more complete appreciation of the disclosure and many of the attendant advantages and features thereof can be readily obtained and understood from the following detailed description with reference to the accompanying drawings, wherein:
FIG. 1 is a schematic diagram illustrating an overall configuration of an image forming apparatus according to a first embodiment of the present disclosure;
FIG. 2 is a control block diagram of the image forming apparatus according to the first embodiment of the present disclosure;
FIG. 3 is a plan view of a liquid discharge unit according to the first embodiment of the present disclosure;
FIG. 4 is an exploded perspective view of the liquid discharge head according to the first embodiment of the present disclosure;
FIG. 5 is a cross-sectional view of the liquid discharge head in a short-side direction of the liquid discharge head, according to the first embodiment of the present disclosure;
FIG. 6 is a cross-sectional view of the piezoelectric actuator according to the first embodiment of the present disclosure;
FIG. 7 is a plan view of the piezoelectric actuator viewed from a diaphragm side, according to the first embodiment of the present disclosure;
FIG. 8 is a cross-sectional view of a relevant part of a piezoelectric actuator according to a second embodiment of the present disclosure;
FIG. 9 is a cross-sectional view of a relevant part of a piezoelectric actuator according to a third embodiment of the present disclosure;
FIG. 10 is a diagram illustrating a serial-type liquid discharge unit according to an embodiment of the present disclosure;
FIG. 11 is a cross-sectional view of a piezoelectric actuator according to a comparative example; and
FIG. 12 is a cross-sectional view of a piezoelectric actuator according to a comparative example.

The accompanying drawings are intended to depict embodiments of the present invention and should not be interpreted to limit the scope thereof. The accompanying drawings are not to be considered as drawn to scale unless explicitly noted. Also, identical or similar reference numerals designate identical or similar components throughout the several views.

### DETAILED DESCRIPTION

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Referring now to the drawings, embodiments of the present disclosure are described below. As used herein, the singular forms "a," "an," and "the" are intended to include the plural forms as well, unless the context clearly indicates otherwise.

With reference to the drawings, descriptions are given below of embodiments of the present disclosure. In the drawings for illustrating embodiments of the present disclosure, like reference signs are assigned to elements such as components and parts that have a like function or a like shape as far as distinguishable, and descriptions of such elements may be omitted once the description is provided.

### Configuration of Image Forming Apparatus

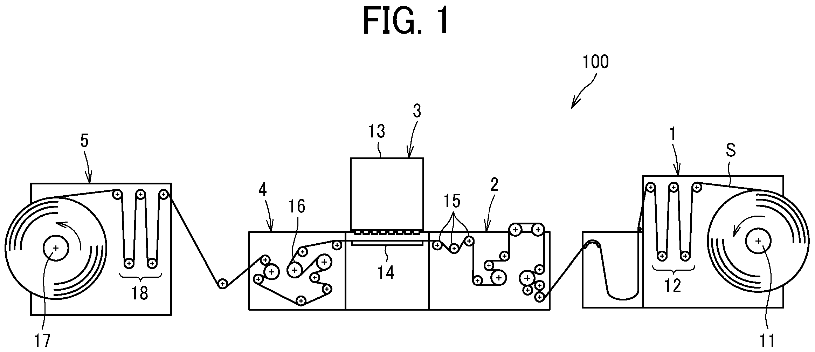

A configuration of an inkjet image forming apparatus, which is a liquid discharge apparatus according to embodiments of the present disclosure, is described below with reference to FIG. 1. FIG. 1 is a schematic diagram illustrating an overall configuration of an image forming apparatus 100 according to a first embodiment of the present disclosure.

As illustrated in FIG. 1, the image forming apparatus 100 of the first embodiment includes a sheet feeder 1, a sheet conveyor 2, an image former 3, a dryer 4, and a sheet collector 5.

The sheet feeder 1 supplies a sheet S. Specifically, the sheet feeder 1 includes a feeding roller 11 and a tension adjustment mechanism 12. A long sheet S is wound around the feeding roller 11 in a roll shape. When the feeding roller 11 rotates, the sheet S is fed from the feeding roller 11.

The tension adjustment mechanism 12 adjusts the tension of the sheet S to feed the sheet S with a constant tension. Specifically, the tension adjustment mechanism 12 includes multiple rollers over which the sheet S is stretched. Some of the multiple rollers of the tension adjustment mechanism 12 move to adjust the tension of the sheet S. By so doing, the sheet S is fed with a constant tension.

The sheet conveyor 2 conveys the sheet S supplied from the sheet feeder 1 to the image former 3. Specifically, the sheet conveyor 2 includes multiple conveyance rollers 15 as conveyors to convey the sheet S. The sheet conveyor 2 may be, for example, a conveyance belt other than the conveyance rollers 15. The conveyance rollers 15 rotate with the sheet S stretched over the conveyance rollers 15. By so doing, the sheet S is conveyed to the image former 3.

The image former 3 forms an image on the sheet S. Specifically, the image former 3 includes a liquid discharge unit 13 and a conveyance guide 14. The liquid discharge unit 13 discharges liquid ink onto the sheet S.

The conveyance guide 14 is a guide and disposed to face a lower side of the liquid discharge unit 13. When the sheet S is conveyed onto the conveyance guide 14, the sheet S is guided along the conveyance guide 14. Then, the liquid discharge unit 13 discharges ink onto the sheet S on the conveyance guide 14. By so doing, an image is formed on the sheet S.

The dryer 4 dries the sheet S on which the ink has been discharged. Specifically, the dryer 4 includes a heating roller 16 that heats the sheet S. The heating roller 16 is an example of a heating device and is a cylindrical roller including a heating source such as a halogen heater therein.

The sheet S is conveyed while being wound around the outer circumferential surface of the heating roller 16. By so doing, the sheet S is heated, and the liquid component contained in the ink is evaporated. Thus, the sheet S is dried. The heating device that heats the sheet S may be a contact-type heater such as the heating roller 16 or a non-contact-type heater such as a hot air generator that blows hot air onto the sheet S.

The sheet collector 5 collects the sheet S. Specifically, the sheet collector 5 includes a collection roller 17 and a tension adjustment mechanism 18. When the sheet S is conveyed to the sheet collector 5, the collection roller 17 rotates to wind the sheet S in a roll shape to collect the sheet S.

The tension adjustment mechanism 18 includes multiple rollers, similar to the tension adjustment mechanism 12 of the sheet feeder 1. Some of the multiple rollers of the tension adjustment mechanism 18 move to adjust the tension applied to the sheet S. By so doing, the sheet S is wound by the collection roller 17 with a constant tension.

### Control Configuration of Image Forming Apparatus

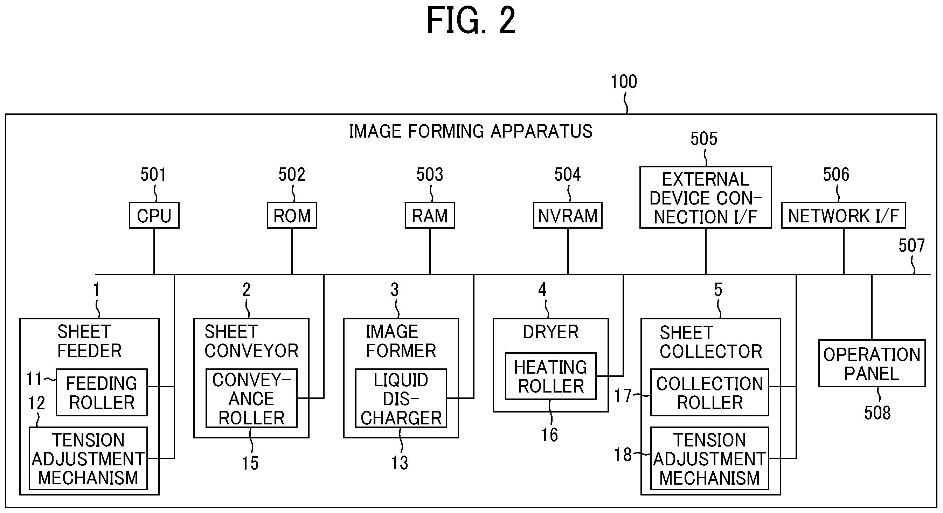

FIG. 2 is a control block diagram of the image forming apparatus 100 according to the first embodiment of the present disclosure.

As illustrated in FIG. 2, the image forming apparatus 100 of the first embodiment includes a central processing unit (CPU) 501, a read-only memory (ROM) 502, a random-access memory (RAM) 503, a non-volatile random-access memory (NVRAM) 504, an external device connection interface (I/F) 505, a network I/F 506, a bus line 507, and an operation panel 508.

The CPU 501 controls the entire operation of the image forming apparatus 100. More specifically, the CPU 501 controls, for example, the discharge operation of the liquid discharge unit 13, the rotation speeds of the feeding roller 11, the collection roller 17, and the conveyance roller 15, the temperature of the heating roller 16, the tensile force adjusting operation of the tension adjustment mechanisms 12 and 18. The ROM 502 stores programs, such as an initial program loader (IPL), used for driving the CPU 501. The RAM 503 is used as a work area for the CPU 501. The NVRAM 504 stores various kinds of data such as a program, and retains various kinds of data while the power source of the image forming apparatus 100 is cut out.

The external device connection I/F 505 is connected to a personal computer (PC) via a universal serial bus (USB) cable and communicates with the PC to exchange control signals or print data of images to be printed with the PC. The network I/F 506 is an interface used to exchange data with an external device through a communication network such as the Internet. The bus line 507 is, for example, an address bus or a data bus, which electrically connects the multiple components such as the CPU 501 to each other.

The operation panel 508 includes, for example, a touch panel and an alarm lamp that display, for example, current set values and a panel of options to be selected and accept inputs from an operator. The CPU 501 controls various operations of the image forming apparatus 100 based on, for example, image data, a sheet conveyance speed, and a sheet type, input through the operation panel 508.

### Configuration of Liquid Discharge Unit

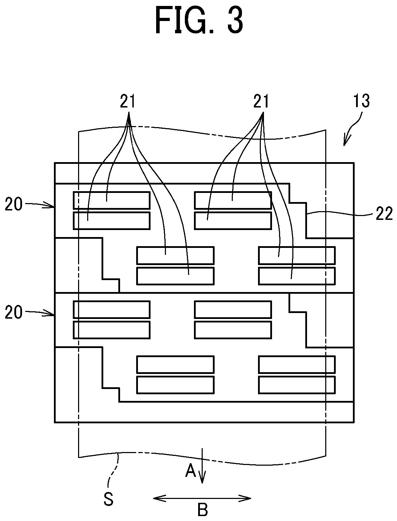

FIG. 3 is a plan view of the liquid discharge unit 13 according to the first embodiment of the present disclosure.

As illustrated in FIG. 3, the liquid discharge unit 13 of the first embodiment includes two liquid discharge heads 20 arranged in a sheet conveyance direction A indicated by arrow A, in which the sheet S is conveyed. Each of the liquid discharge heads 20 includes, for example, multiple head bodies 21 that discharge ink, and a base 22 that holds the head bodies 21.

The head bodies 21 extend long in a sheet width direction B indicated by arrow B, which is a direction orthogonal to the sheet conveyance direction A. The head bodies 21 are arranged side by side in the sheet conveyance direction A in pairs. Further, four pairs of adjacent head bodies 21 are each arranged in the sheet conveyance direction A and the sheet width direction B.

In FIG. 3, in each of the liquid discharge heads 20, the two pairs of upper head bodies 21 and the two pairs of lower head bodies 21 are arranged so as to be shifted from each other in the sheet width direction B. As described above, the two pairs of upper head bodies 21 and the two pairs of lower head bodies 21 are arranged so as to be shifted from each other in the sheet width direction B. By so doing, the liquid discharge unit 13 can discharge ink over an entire region in the width direction of the image formation region of the sheet S.

Accordingly, when the sheet S is conveyed to a position facing the liquid discharge unit 13, the ink is discharged from the head bodies 21 while the liquid discharge unit 13 does not move with respect to the conveyed sheet S. Thus, an image is formed on the sheet S. FIG. 3 illustrates an example of the configuration of the liquid discharge unit 13, and, for example, the arrangement, the number of the head bodies 21 are not limited to this example.

### Configuration of Liquid Discharge Head

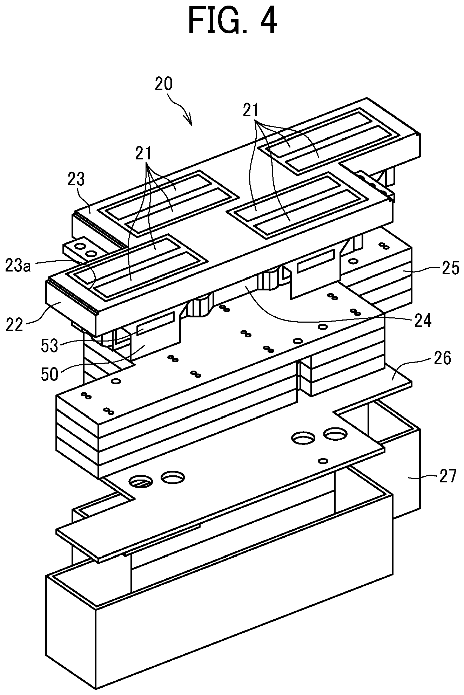

FIG. 4 is an exploded perspective view of the liquid discharge head 20 according to the first embodiment of the present disclosure.

As illustrated in FIG. 4, the liquid discharge head 20 of the first embodiment includes, for example, the multiple head bodies 21, the base 22, a cover 23, a heat dissipator 24, a manifold 25, a printed circuit board (PCB) 26, a module case 27, and a flexible wiring 50.

The multiple head bodies 21 are fixed to the base 22 and held by the base 22. Examples of methods of fixing the head bodies 21 to the base 22 include, in addition to fastening by screws, a method such as adhesion or caulking. One side of the base 22 is covered with the cover 23.

The cover 23 has holes 23a at positions corresponding to the respective head bodies 21. Accordingly, the liquid discharge face of each of the head bodies 21 is disposed so as to be exposed through the hole 23a. The module case 27 is attached to the base 22 on a side of the base 22 opposite a side of the base 22 on which the head bodies 21 are exposed. The heat dissipator 24, the manifold 25, the PCB 26, and a part of the flexible wiring 50 including a driver integrated circuit (IC) 53 are accommodated in the module case 27.

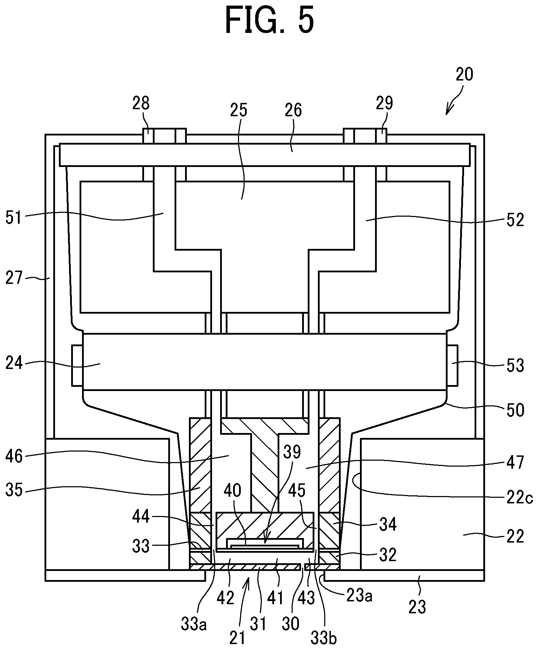

FIG. 5 is a cross-sectional view of the liquid discharge head 20 in the short-side direction of the liquid discharge head 20, according to the first embodiment of the present disclosure.

As illustrated in FIG. 5, in the liquid discharge head 20 of the first embodiment, the head body 21 is accommodated in a hole 22c of the base 22. The head body 21 includes a nozzle plate 31, a piezoelectric actuator 39, a holding substrate 34, and a common channel substrate 35. The piezoelectric actuator 39 includes a channel substrate 32, a diaphragm 33, and a piezoelectric element 40. The piezoelectric element 40 is connected to the PCB 26 via the flexible wiring 50.

The nozzle plate 31 is a plate-shaped member having nozzles 30 to discharge ink. A peripheral area of the nozzle plate 31 excluding an area in which the nozzles 30 are disposed, is joined to the cover 23. By contrast, the nozzles 30 are disposed so as to be exposed through the holes 23a of the cover 23.

The channel substrate 32 is a base to which the nozzle plate 31, the diaphragm 33, and the piezoelectric element 40 are mounted. Specifically, the nozzle plate 31 is bonded to a liquid discharge side of the channel substrate 32, and the diaphragm 33 and the piezoelectric element 40 are bonded to the opposite side of the channel substrate 32 in this order.

In addition, the channel substrate 32 includes individual liquid chambers 41 which communicate with the respective nozzles 30 of the nozzle plate 31, supply side individual channels 42 communicating with the respective individual liquid chambers 41, and collection side individual channels 43. The collection side individual channels 43 communicate with the respective individual liquid chambers 41 on an end of the channel substrate 32 opposite the other end at which the supply side individual channels 42 is positioned.

The holding substrate 34 holds the nozzle plate 31 and the piezoelectric actuator 39. More specifically, the diaphragm 33 is bonded to the holding substrate 34. By so doing, the nozzle plate 31, the channel substrate 32, the diaphragm 33, and the piezoelectric element 40 are held by the holding substrate 34.

In addition, the holding substrate 34 includes a supply side intermediate individual channel 44 and a collection side intermediate individual channel 45. The supply side intermediate individual channel 44 communicates with the supply side individual channel 42 via a hole 33a disposed in the diaphragm 33. The collection side intermediate individual channel 45 communicates with the collection side individual channel 43 via a hole 33b disposed in the diaphragm 33.

The common channel substrate 35 fixes the holding substrate 34 to the base 22. The holding substrate 34 is bonded to the common channel substrate 35, and the common channel substrate 35 is fixed to the base 22. By so doing, all of the head bodies 21 are held by the base 22.

The common channel substrate 35 defines a supply side common channel 46 and a collection side common channel 47. The supply side common channel 46 communicates with the supply side intermediate individual channels 44. The collection side common channel 47 communicates with the collection side intermediate individual channels 45. The supply side common channel 46 is arranged so as to communicate with a supply port 28 via a channel 51 of the manifold 25, and the collection side common channel 47 is arranged so as to communicate with a collection port 29 via a channel 52 of the manifold 25.

The base 22 is preferably formed of a material having a low coefficient of linear expansion. Examples of the material of the base 22 include Alloy 42 in which nickel is added to iron and an invar material. Forming the base 22 with such materials as described above can reduce the amount of thermal expansion of the base 22 when the liquid discharge head 20 generates heat.

Accordingly, the positional deviation of the nozzles 30 due to the thermal expansion of the base 22 can be reduced, and the positional deviation of discharged droplets with respect to the sheet can be reduced. The nozzle plate 31 and the diaphragm 33 may be formed of single crystal silicon, and the coefficients of linear expansion of the nozzle plate 31 and the diaphragm 33 may be substantially the same as the coefficient of linear expansion of the base 22. The coefficients of linear expansion of the nozzle plate 31 and the diaphragm 33 are substantially the same as the coefficient of linear expansion of the base 22. By so doing, the positional deviation of the nozzles 30 due to thermal expansion can be further reduced.

### Configuration of Head Body

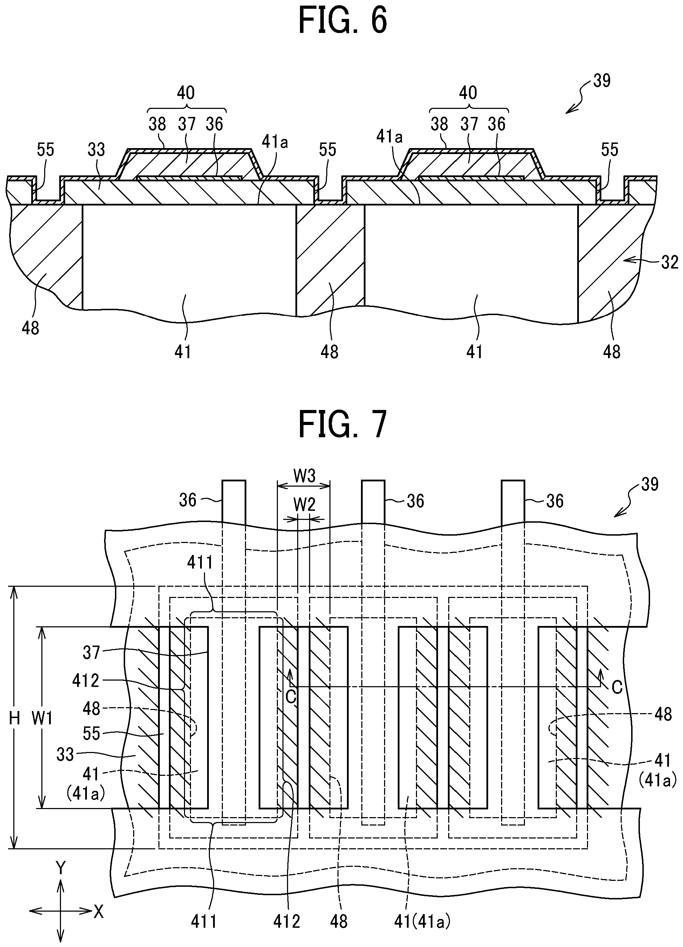

FIG. 6 is a cross-sectional view of the piezoelectric actuator 39 according to the first embodiment of the present disclosure.

As illustrated in FIG. 6, in the piezoelectric actuator 39 of the first embodiment, the channel substrate 32 includes the multiple individual liquid chambers 41 and partition walls 48 that partition the individual liquid chambers 41. The nozzles 30 are disposed one by one below each of the individual liquid chambers 41 in FIG. 6. Thus, the nozzles 30 are arranged in a direction parallel to the direction in which the individual liquid chambers 41 are arranged.

The diaphragm 33 is disposed on the partition walls 48 of the channel substrate 32 so as to cover slots 41a of the individual liquid chambers 41. The diaphragm 33 is disposed so as to cover the slots 41a entirely at an upper portion in FIG. 6. By so doing, the diaphragm 33 defines one surface of the individual liquid chambers 41.

The channel substrate 32 is formed using, for example, single crystal silicon having a thickness of 80 µm. When the single crystal silicon is used as the material of the channel substrate 32, the individual liquid chambers 41 can be formed finely and highly accurately by a semiconductor processing technology such as photolithography. The material of the channel substrate 32 is not limited to the single crystal silicon, and a material suitable for processing the individual liquid chambers 41 can be selected from any metal, such as, alloy, ceramic, and semiconductor.

The piezoelectric element 40 is disposed on a side of the diaphragm 33 opposite the other side of the diaphragm 33 bonded to the channel substrate 32. The piezoelectric element 40 includes a first electrode 36, a piezoelectric body 37, and a second electrode 38 in order from the diaphragm 33. The first electrode 36 is an individual electrode individually disposed for each of the individual liquid chambers 41. Alternatively, the second electrode 38 is a common electrode disposed for over the individual liquid chambers 41 in common. The piezoelectric body 37 is interposed between the first electrode 36 and the second electrode 38.

The diaphragm 33, the first electrode 36, the piezoelectric body 37, and the second electrode 38 are laminated one on another on the channel substrate 32. Examples of a method of laminating the diaphragm 33, the first electrode 36, the piezoelectric body 37, and the second electrode 38 on the channel substrate 32 include patterning the diaphragm 33, the first electrode 36, the piezoelectric body 37, and the second electrode 38 by photolithography. The photolithography includes, for example, a chemical vapor deposition (CVD) method, a sputtering method, an atomic layer deposition (ALD) method, and a spin coating method.

In the piezoelectric actuator 39 as described above, when a predetermined drive voltage is applied to the first electrode 36 and the second electrode 38, the piezoelectric body 37 is deformed. When the piezoelectric body 37 is deformed, the diaphragm 33 is deformed so as to protrude into the individual liquid chambers 41. Accordingly, the ink in the individual liquid chambers 41 is pressurized, and the ink is discharged from the nozzles 30.

As the material of the diaphragm 33, for example, a silicon-based compound or a zirconium-based compound can be used. As the silicon-based compound, a material containing at least silicon dioxide such as a silica (SiO2) is favorable to facilitate manufacturing the diaphragm 33.

Other silicon-based compounds include, for example, monocrystalline silicon, polycrystalline silicon, silicon-nitride (Si3N4), and silicon-carbide (SiC). In addition, examples of the zirconium-based compound include zirconium oxide (ZrO2). The thickness of the diaphragm 33 is set to a thickness in accordance with the vibration characteristics and the amount of strain needed for the piezoelectric actuator as appropriate. For example, the thickness of the diaphragm 33 is preferably in the range of 1 µm to 3 µm.

Examples of the materials of the first electrode 36 and the second electrode 38 include metals such as platinum (Pt) and iridium (Ir), and conductive oxides such as iridium oxides (IrO2), tin monoxide (SnO), and indium oxides (InO2). Examples of the material of the piezoelectric body 37 include lead zirconate titanate (PZT).

In particular, lead zirconate titanate in which the ratio of zinc (Zn) to titanium (Ti) is adjusted to 53:47 can provide favorable characteristics. The ratio of each constituent element of lead zirconate titanate may be adjusted as appropriate, in accordance with the molding method, molding conditions, and target performance of the piezoelectric body 37. For example, adjusting the ratio of zinc to titanium in the range of 43:57 to 63:37, allows the piezoelectric body 37 to obtain favorable piezoelectric properties. In addition, an element such as manganese (Mn), niobium (Nb), molybdenum (Mo), or cobalt (Co) may be added (doped) to lead zirconate titanate.

The widths of the first electrode 36 and the piezoelectric body 37 can be appropriately set according to a desired deformation amount and the manufacturing method of the piezoelectric actuator 39. For example, when the width of the slot 41a of the individual liquid chamber 41 is 60 µm, the width of the piezoelectric body 37 is 50 µm and the width of the first electrode 36 is 40 µm. By so doing, favorable deformation characteristics can be obtained. The thickness of the piezoelectric body 37 can be set as appropriate in accordance with the performance needed for the piezoelectric actuator 39. The thickness of the piezoelectric body 37 is preferably in a range of from, for example, 1 µm to 4 µm.

The distance between the adjacent slots 41a of the individual liquid chambers 41 is set to, for example, 85 µm. The widths of the slots 41a in an arrangement direction in which the slots 41a are arranged, i.e., the horizontal direction in FIG. 6, are set to, for example, 60 µm. The widths of the slots 41a in a direction orthogonal to the arrangement direction, i.e., the direction orthogonal to the sheet surface of FIG. 6, are set to, for example, 600 µm. The widths of the slot 41a in the arrangement direction and the direction orthogonal to the arrangement direction may be set to appropriate widths in accordance with specifications needed for the piezoelectric actuator 39 and the liquid discharge head 20.

### Challenges in Liquid Discharge Head

A description is given of challenges of the liquid discharge head 20 by taking the configuration of the liquid discharge head 20 of the first embodiment of the present disclosure as an example.

The diaphragm 33 of the liquid discharge head 20 is typically molded by a method such as physical vapor deposition (PVD) or thermal oxidation of the channel substrate 32 in addition to the CVD method. In any of the methods, the diaphragm 33 is molded in a heated space. Accordingly, residual stress is generated in the diaphragm 33 after the diaphragm 33 is molded.

At this time, if the residual stress that is generated in the diaphragm 33 is large, the stress that is caused by the deformation of the diaphragm 33 at the time at which liquid is discharged is also added to the residual stress, and a large stress acts on the diaphragm 33. For this reason, damage such as a crack may occur in the diaphragm 33. For example, when a tensile stress that pulls the diaphragm 33 from the periphery is generated, the diaphragm 33 may be deformed so as to protrude toward the individual liquid chamber 41 at the time at which liquid is discharged. At this time, a large stress acts on the diaphragm 33, particularly in the periphery of the slot 41a of the individual liquid chamber 41.

As a result, the diaphragm 33 may be damaged. By contrast, when compressive stress is generated in the diaphragm 33, the diaphragm 33 tends to expand. Accordingly, deformation such as buckling occurs in the diaphragm 33. Under the above conditions, when the diaphragm 33 is deformed at the time at which the liquid is discharged, the diaphragm 33 is deformed unevenly. As a result, the diaphragm 33 may be damaged.

When warping of the diaphragm 33 occurs due to the residual stress, the warping is corrected when the diaphragm 33 is bonded to the channel substrate 32 and the piezoelectric element 40. By so doing, a load is applied to the diaphragm 33, the channel substrate 32, and the piezoelectric element 40. As a result, the diaphragm 33, the channel substrate 32, and the piezoelectric element 40 that are bonded to each other may be damaged.

In addition, when the warping that is generated in the diaphragm 33 is large, a conveyance failure and a suction failure may occur when the diaphragm 33 is conveyed or sucked in the manufacturing process.

As described above, in the liquid discharge head 20, defects such as the conveyance failure and the suction failure in the manufacturing process may occur in addition to damage to the diaphragm 33 due to the influence of the residual stress generated in the diaphragm 33. Selecting a material that is less likely to generate the residual stress and the warping as the material of the diaphragm 33, can prevent disadvantages as described above from occurring. However, selecting the material of the diaphragm 33 from a limited range of materials narrows the range of material selection.

The material of the diaphragm 33 significantly contributes to the crystalline state of the piezoelectric body 37 in addition to the manufacturing cost and the ease of manufacturing. For this reason, preferably, the material of the diaphragm 33 is selected from a wide range of materials to obtain a favorable crystalline state of the piezoelectric body 37. Therefore, it is difficult to adopt the method of selecting the material of the diaphragm 33 from limited materials in order to secure a wide range of material selection.

In view of the above circumstances, in the first embodiment of the present disclosure, the diaphragm 33 has a configuration as described below to reduce the residual stress generated in the diaphragm 33.

### Configuration of Diaphragm of the First Embodiment

A description is given below of the configuration of the diaphragm 33 according to the first embodiment with reference to FIGS. 6 and 7.

As illustrated in FIG. 6, the diaphragm 33 of the first embodiment has through holes 55. The through holes 55 are disposed on the respective partition walls 48 of the channel substrate 32. The through holes 55 are disposed so as to penetrate the diaphragm 33. In other words, the through holes 55 penetrate the diaphragm 33 in a direction intersecting a face of the diaphragm 33 bonded to the channel substrate 32. Further, since the diaphragm 33 has the through holes 55, the second electrode 38 that covers the diaphragm 33 is formed so as to enter and cover the respective through holes 55.

FIG. 7 is a plan view of the piezoelectric actuator 39 according to the first embodiment, viewed from the diaphragm 33 side. Note that FIG. 6 is a cross-sectional view taken along line C-C in FIG. 7.

As illustrated in FIG. 7, each of the through holes 55 is disposed so as to surround the entire slot 41a of the individual liquid chamber 41. In the first embodiment, the multiple slots 41a are arranged adjacent to each other. Accordingly, the through holes 55 are disposed so as to surround the respective slots 41a one by one.

Each of the slots 41a is formed in a rectangular shape having two short side portions 411 and two long side portions 412. The short side portions 411 extend in the short-side direction of the slot 41a indicated by double-headed arrow X. The long side portions 412 extend in the longitudinal direction indicated by double-headed arrow Y Accordingly, the through hole 55 is disposed along the short side portions 411 and the long side portions 412 of the slot 41 a so as to surround the slot 41a entirely.

As described above, the diaphragm 33 of the first embodiment, has the through holes 55 each surrounding the slot 41a entirely. Accordingly, the residual stresses of the diaphragm 33 around the slots 41a can be reduced.

Therefore, the piezoelectric actuator 39 of the first embodiment can prevent the diaphragm 33 from being ruptured. In addition, the residual stress of the diaphragm 33 is reduced. For this reason, the warping of the diaphragm 33 can also be prevented from occurring. Thus, the load that is generated in a bonding portion between the diaphragm 33 and the channel substrate 32 and a bonding portion between the diaphragm 33 and the piezoelectric element 40, can be reduced. Accordingly, the diaphragm 33, the channel substrate 32, and the piezoelectric body 37 can be prevented from being damaged. In addition, the warping of the diaphragm 33 is reduced. For this reason, the conveyance failure and the suction failure of the diaphragm 33 can be reduced in the manufacturing process.

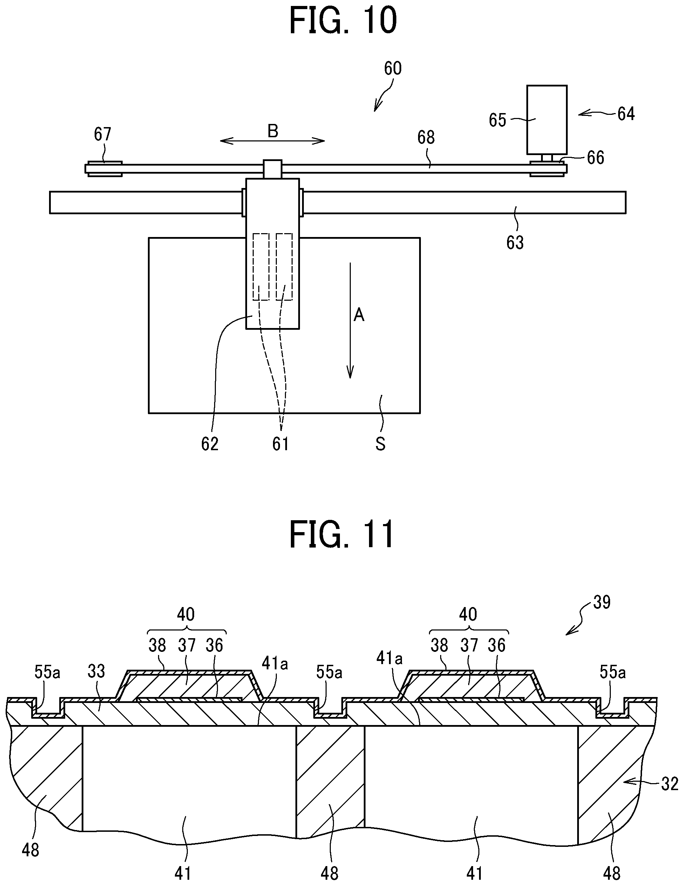

In particular, in the first embodiment, the through holes 55 are disposed so as to penetrate the diaphragm 33. Accordingly, the residual stress of the diaphragm 33 can be effectively reduced as compared with the configuration in which recesses 55a do not penetrate as illustrated in FIG. 11. As a result, the piezoelectric actuator 39 of the first embodiment can reliably prevent the problems caused by the residual stress of the diaphragm 33 from occurring.

The magnitude of the residual stresses that are applied to the diaphragm 33 is preferably within a range of - 400 megapascals (MPa) to 200 MPa. The magnitude of the residual stress can be calculated, for example, from the magnitude of the warping, i.e., a radius of curvature, generated in the diaphragm 33 formed on the channel substrate 32 using the following formula. In the formula, σ is residual stress generated in the diaphragm 33, E is an elastic modulus of the channel substrate 32, v is a Poisson's ratio of the channel substrate 32, ta is the thickness of the channel substrate 32, tb is a thickness of the diaphragm 33, Ra is a radius of curvature of the channel substrate 32 alone, and Rb is a radius of curvature of the diaphragm 33 formed on the channel substrate 32.

### First Formula

The magnitude of the residual stress that is generated in the diaphragm 33 can also be calculated from a diffraction pattern observed by X-ray diffraction method, Raman spectroscopy method, or nano-beam electron diffraction (NBED) method. When the residual stress is generated in the diaphragm 33, a clearance between adjacent lattice planes changes in accordance with the angle between the adjacent lattice planes and the stress direction. For this reason, changing the tilt angle of the diaphragm 33 in the X-ray diffraction allows the lattice plane inclined with respect to the diaphragm 33 to be measured, and the residual stress generated in the diaphragm 33 to be calculated.

Raman spectroscopy is a spectroscopy method based on the inelastic scattering of light. When the residual stress is generated in the diaphragm 33, an interatomic distance changes due to the residual stress applied to the crystal. Typically, the bonding force between atoms depends on the interatomic distance, and the frequency of lattice vibration, i.e., phonon, changes due to the stress. When the compressive stress is generated, the phonon line shifts to a high wave number. When the tensile stress is generated, the phonon line shifts to a low wave number. Accordingly, the residual stress of the measurement sample can be calculated by measuring the difference in the peak value of the phonon line from the diaphragm 33 in which no residual stress is generated.

In the nanobeam electron diffraction method, an electron beam is entered into the diaphragm 33 at a predetermined incident angle using a transmission electron microscope (TEM), to measure a clearance between adjacent lattice planes from the obtained diffraction spot. Then, the strain of lattice is measured from the difference between the measured clearance between adjacent lattice planes and a clearance between the lattice planes of the diaphragm 33 in which the residual stress is not generated. By so doing, the residual stress can be calculated.

The through hole 55 may be disposed over the entire periphery of the slot 41a or may be disposed over a part of the periphery of each slot 41a. However, in order to effectively reduce the residual stress of the diaphragm 33, the through holes 55 are preferably disposed on the respective partition walls 48, i.e., hatched portions in FIG. 7, which are disposed along at least portions of the slot 41a, i.e., the long side portions 412 of the slots 41a extending in the longitudinal direction Y

As illustrated in FIG. 7, the through hole 55 is preferably disposed over a range H, which is wider than a widthwise region W1 of the slots 41a in the longitudinal direction Y The through hole 55 is disposed over the range H wider than the widthwise region W1 of the slots 41a in the longitudinal direction Y Accordingly, the effect of reducing the residual stress of the diaphragm 33 can be further obtained.

A width W2 of the through hole 55 is preferably equal to or smaller than ½ of a width W3 of the partition wall 48. The width W2 of the through hole 55 and the width W3 of the partition wall 48 extend in a direction intersecting with a direction in which the through hole 55 and the partition wall 48 extend along ends of the slot 41a in the X direction on an upper face of the partition wall 48 on which the through hole 55 is disposed.

Setting the width W2 of the through hole 55 to be equal to or smaller than ½ of the width W3 of the partition wall 48 can secure a clearance between the slot 41a and the through hole 55. Accordingly, the ink can be prevented from flowing from the individual liquid chamber 41 into the through hole 55.

### Configurations of Other Embodiments

Next, other embodiments of the present disclosure different from the first embodiment will be described. Differences from the above-described first embodiment are typically described, and descriptions of the same portions are appropriately omitted.

### Second Embodiment

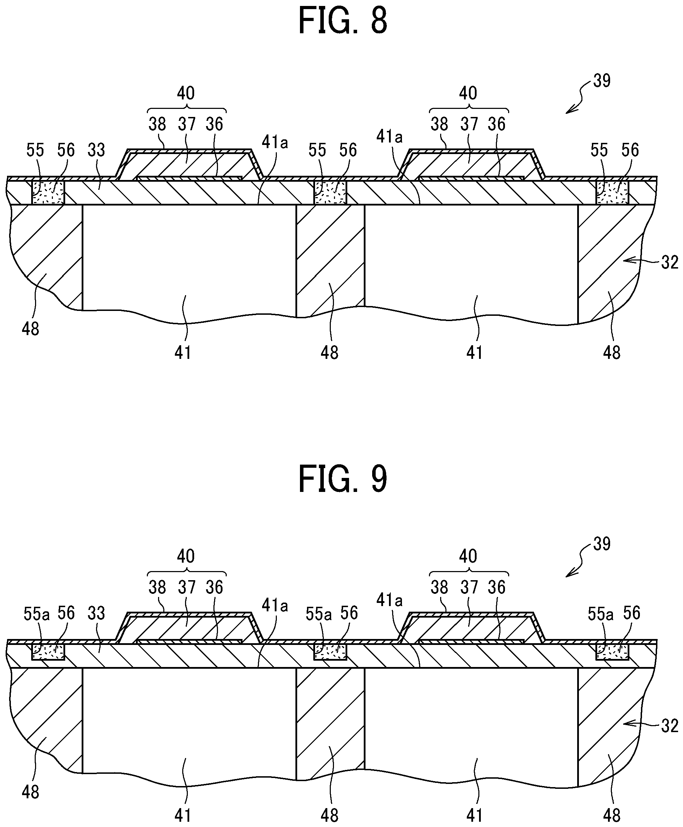

FIG. 8 is a cross-sectional view of a relevant part of the piezoelectric actuator 39 according to a second embodiment of the present disclosure.

As illustrated in FIG. 8, in the second embodiment, the through hole 55 of the diaphragm 33 is filled with a filler 56 having stress directed in a direction opposite the direction in which the stress generated in the diaphragm 33 is directed. The material of the filler 56 is preferably a material containing at least lead zirconate titanate.

The stress of the filler 56 may be any stress as long as the absolute value of the stress is smaller than the absolute value of the stress, i.e., residual stress, generated in the diaphragm 33. For example, when the stress of the diaphragm 33 is - 300 MPa, the stress of the filler 56 may be - 100 MPa, which is smaller than the absolute value of the stress of the diaphragm 33. In this case, the second electrode 38 is disposed so as to cover the face of the filler 56. Other configurations are similar to, even if not the same as, the configurations of the first embodiment.

As described above, in the second embodiment, the filler 56, which has the stress directed in the direction opposite the direction the stress generated in the diaphragm 33 is directed, is filled in the through hole 55. Accordingly, the residual stress generated in the diaphragm 33 can be further reduced.

In other words, since a part or all of the residual stress of the diaphragm 33 is canceled by the stress directed in the direction opposite the direction of the stress of the filler 56. Accordingly, the stress generated in the diaphragm 33 is further reduced. Therefore, in the piezoelectric actuator 39 of the second embodiment, the rupture of the diaphragm 33 due to the residual stress and problems such as conveyance failure and suction failure can be more effectively prevented in the manufacturing process.

For example, the diaphragm 33 is formed of silicon dioxide and the filler 56 is formed of lead zirconate titanate. By so doing, the filler 56 can have a stress directed in the direction opposite to the direction the stress of the diaphragm 33 is directed. In other words, the filler 56 is formed with lead zirconate titanate having the stress directed in the direction opposite a direction in which the stress of the silicon dioxide is directed. By so doing, the filler 56 has the stress directed in the direction opposite the direction in which the stress of the diaphragm 33 is directed.

Whether the stress of the filler 56 is smaller than the stress of the diaphragm 33 can be determined by, for example, the magnitude of the warping generated in the diaphragm 33, or the X-ray diffraction. When the piezoelectric body 37 and the filler 56 are formed of the same material such as lead zirconate titanate, the magnitude relation between the stress of the filler 56 and the stress of the diaphragm 33 can be determined by checking the extent to which a bonded portion between the diaphragm 33 and the piezoelectric body 37 is bent toward the individual liquid chamber 41 or the piezoelectric body 37.

When the bonded portion between the diaphragm 33 and the piezoelectric body 37 protrudes toward the individual liquid chamber 41, it can be determined that the stress of the filler 56 is larger than the stress of the diaphragm 33. By contrast, when the bonded portion between the diaphragm 33 and the piezoelectric body 37 protrudes toward the piezoelectric body 37, it can be determined that the stress of the filler 56 is smaller than the stress of the diaphragm 33.

In order to form the filler 56 with the same material as the piezoelectric body 37, the through holes 55 are first formed in the diaphragm 33 before the piezoelectric body 37 is laminated on the diaphragm 33. Subsequently, the piezoelectric body 37 is formed on the entire face of the diaphragm 33 including the through holes 55 by, for example, a spin coating method, or a sputtering method. Then, photolithography and etching is performed on a portion of the diaphragm 33 in which the piezoelectric body 37 needs to be formed. By so doing, the filler 56 that is made of the same material as the piezoelectric body 37, is formed in the through hole 55.

### Third Embodiment

FIG. 9 is a cross-sectional view of a relevant part of the piezoelectric actuator 39 according to a third embodiment of the present disclosure.

In the piezoelectric actuator 39 of the third embodiment illustrated in FIG. 9, the recess 55a of the diaphragm 33 does not penetrate the diaphragm 33. The recess 55a is filled with the filler 56 having a stress directed in a direction opposite the direction the stress generated in the diaphragm 33 directs. Accordingly, in the piezoelectric actuator 39 of the third embodiment, the second electrode 38 is also disposed so as to cover an upper face of the filler 56. Other configurations of the third embodiment are similar to, even if not the same as, the configurations of the first embodiment.

As described above, in the piezoelectric actuator 39 of the third embodiment, the recess 55a does not penetrate the diaphragm 33. For this reason, the effect of reducing the residual stress of the diaphragm 33 by the recesses 55a is less likely to be obtained compared to the piezoelectric actuator 39 of the first embodiment in which the through hole 55 penetrates the diaphragm 33.

However, in the piezoelectric actuator 39 of the third embodiment, the filler 56 that has the stress directed in the direction opposite the direction in which the stress generated in the diaphragm 33 is directed, is filled in the recess 55a. Accordingly, the effect of reducing the residual stress of the diaphragm 33 can be enhanced. Accordingly, in the piezoelectric actuator 39 of the third embodiment, the residual stress that is generated in the diaphragm 33 can be reduced, and the rupture of the diaphragm 33 due to the residual stress and the problems such as the conveyance failure and the suction failure in the manufacturing process can be more effectively prevented.

### Durability Test of Piezoelectric Actuator

Next, a description is given of a durability test performed using the piezoelectric actuator 39 according to embodiments of the present disclosure and a piezoelectric actuator 39A according to a comparative example.

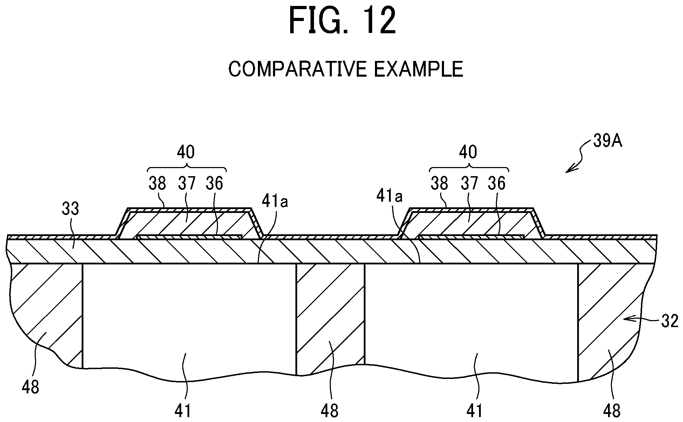

The durability test was performed using the piezoelectric actuator 39 of the first embodiment illustrated in FIG. 6, the piezoelectric actuator 39 of the second embodiment illustrated in FIG. 8, and the piezoelectric actuator 39A according to the comparative example illustrated in FIG. 12. In the piezoelectric actuator 39A of the comparative example, the diaphragm 33 does not have the through holes 55 nor the recesses 55a.

In any of the first embodiment, second embodiment, and the comparative example, the diaphragm 33 was 2 µm thick, and the magnitude of the residual stresses generated in the diaphragm 33 was 100 MPa. In the piezoelectric actuators according to the first and second embodiments of the present disclosure, the width of the through hole 55 is 20 µm. In the piezoelectric actuator 39 of the second embodiment, the filler 56 is stressed to -100 MPa.

In the piezoelectric actuator 39 of the first and second embodiments and the piezoelectric actuator 39A of the comparative example thus configured as described above, an alternating current (AC) voltage was applied to the first electrode 36 and the second electrode 38 under the following conditions. Then, it was checked whether, for example, the diaphragm 33, and the piezoelectric body 37 were cracked or damaged by discharge with a microscope.
Voltage: 0 V to 40 V Pulse frequency: 120 kHz Pulse duty: 50% (time ratio at which voltage per pulse cycle is 40 V)
Number of pulses applied: 10¹¹ times

The voltage that is applied to the first electrode 36 and the second electrode 38 is not limited to the AC voltage, and may be a direct-current (DC) voltage. Further, an acceleration test in which the applied voltage, temperature, and humidity are changed, may be performed.

The durability test that examines the durability of the piezoelectric actuator 39 is not limited to the conditions of the above-described durability test, and appropriate test conditions can be set in accordance with the use and desired performance of the piezoelectric actuator 39.

As a result of the durability test under the above conditions, in the piezoelectric actuator 39A of the comparative example, a crack occurred when the number of applied pulses reached 5¹¹ times. By contrast, in the piezoelectric actuator 39 of the first and second embodiments of the present disclosure, no crack occurred even when the number of applied pulses reached 10¹¹ times.

Further, when the warps generated in the diaphragm 33 were compared, the piezoelectric actuator 39 of the first embodiment had a smaller warp than the piezoelectric actuator 39A of the comparative example. The piezoelectric actuator 39 of the second embodiment had a smaller warp than the piezoelectric actuator 39 of the first embodiment.

From the above, it was confirmed that in the piezoelectric actuator 39 of the first and second embodiments, the warping of the piezoelectric element 40 including the diaphragm 33 can be reduced and the occurrence of cracks can be reduced as compared with the piezoelectric actuator 39A of the comparative example. Therefore, in the first and second embodiments of the present disclosure, warping and breakage of the piezoelectric element 40 can be prevented due to the residual stress of the diaphragm 33.

The present disclosure is not limited to the above-described embodiments. Various modifications can be made without departing from the scope of the gist of the present disclosure.

For example, the embodiments of the present disclosure are not limited to the line-type liquid discharge unit 13 as illustrated in FIG. 3, and can be applied to a serial-type liquid discharge unit 60 as illustrated in FIG. 10. A brief description is given of the configuration and operation of the serial-type liquid discharge unit 60 with reference to FIG. 10.

The serial-type liquid discharge unit 60 illustrated in FIG. 10 includes a carriage 62 on which liquid discharge heads 61 are mounted, a guide 63 for guiding the carriage 62 in the sheet width direction B, and a driving device 64 for moving the carriage 62.

The driving device 64 includes, for example, a motor 65 as a driving source, and a timing belt 68 wound around a driving pulley 66 and a driven pulley 67. When the motor 65 is driven and the driving pulley 66 rotates, the timing belt 68 circumferentially moves. By so doing, the carriage 62 moves in the sheet width direction B along the guide 63.

In the serial-type liquid discharge unit 60, the ink is discharged from the liquid discharge heads 61 in response to the image signal while the carriage 62 moves in the sheet width direction B. By so doing, an image for one line is formed on the sheet P that remains stationary. Subsequently, reciprocal movement of the carriage 62 and ink discharge operation are repeatedly performed while the sheet S is conveyed in the sheet conveying direction A by a predetermined amount. By so doing, an image is formed on the sheet S.

The liquid discharge apparatus according to embodiments of the present disclosure includes various liquid discharge apparatuses as long as the liquid discharge apparatus includes a liquid discharge unit and discharges liquid onto a sheet by driving the liquid discharge unit, in addition to the inkjet image forming apparatus as an example of the liquid discharge apparatus.

The liquid discharge apparatus according to embodiments of the present disclosure is not limited to an apparatus that discharges liquid to visualize meaningful images such as characters or figures. For example, the liquid discharge apparatus may be an apparatus that forms patterns having no meaning or an apparatus that fabricates three-dimensional images. The liquid discharge apparatus further includes, for example, a treatment-liquid discharge apparatus that discharges treatment liquid onto the surface of a sheet for the purposes of, for example, reforming the surface of the sheet.

The liquid discharge apparatus according to embodiments of the present disclosure may include an aftertreatment device in addition to a device relating to feeding, conveying, and ejecting of a sheet and a pretreatment device. In the liquid discharge apparatus according to embodiments of the present disclosure, the liquid discharge unit may move relative to the sheet, or may not move relative to the sheet. Specific examples of the liquid discharge apparatus include a serial-type liquid discharge apparatus as illustrated in FIG. 10 and a line-type liquid discharge apparatus as illustrated in FIG. 3. The liquid discharge head may include multiple head bodies or may include one head body.

The sheet onto which liquid is discharged is an object onto which liquid is at least temporarily adhered, and includes, for example, a sheet to which liquid is adhered and fixed and a sheet to which liquid adheres and permeates. Specific examples of the sheet include a recording medium such as a sheet of paper, a recording sheet, a film, and cloth, and an electronic substrate. Examples of the material of the sheet include any materials to which liquid can adhere even temporarily, such as paper, thread, fiber, fabric, leather, metal, plastic, glass, wood, and ceramic. The sheet may be a long sheet wound in a roll shape such as a roll paper, or a sheet cut into a predetermined size in the sheet conveyance direction in advance such as a cut sheet.

The liquid discharge device according to embodiments of the present disclosure includes, in addition to apparatuses to discharge liquid to a material onto which liquid can adhere, apparatuses to discharge liquid into gas (air) or liquid.

The liquid to be discharged from the liquid discharge apparatus according to embodiments of the present disclosure is not limited to a particular liquid as long as the liquid has a viscosity or surface tension to be discharged from a liquid discharge unit (liquid discharge head). However, preferably, the viscosity of the liquid is not greater than 30 millipascal-second (mPa·s) under ordinary temperature and ordinary pressure or by heating or cooling. Examples of the liquid include a solution, a suspension, or an emulsion that contains, for example, a solvent, such as water or an organic solvent, a colorant, such as dye or pigment, a functional material, such as a polymerizable compound, a resin, or a surfactant, a biocompatible material, such as deoxyribonucleic acid (DNA), amino acid, protein, or calcium, or an edible material, such as a natural colorant. Such a solution, a suspension, or an emulsion can be used for, e.g., inkjet ink, surface treatment solution, a liquid for forming components of an electronic element or light-emitting element or a resist pattern of electronic circuit, or a material solution for three-dimensional fabrication.

The above-described embodiments of the present disclosure have at least the following aspects.

### First Aspect

A piezoelectric actuator includes a base having a slot and a partition wall to partition the slot, a diaphragm disposed on the partition wall so as to cover the slot, and a piezoelectric element disposed on a face of the diaphragm opposite the other face of the diaphragm bonded to the base. The diaphragm is a piezoelectric actuator having a recess penetrating the diaphragm on the partition wall and the recess is arranged along at least a portion of the slot extending in a longitudinal direction of the slot.

### Second Aspect

In the piezoelectric actuator according to the first aspect, the recess is filled with a filler having a stress directed in a direction opposite a direction in which a stress generated in the diaphragm is directed.

### Third Aspect

A piezoelectric actuator includes a base having a slot and a partition wall that partitions the slot, a diaphragm disposed on the partition wall so as to cover the slot, and a piezoelectric element disposed on a side of the diaphragm opposite a side of the diaphragm bonded to the base. The diaphragm is a piezoelectric actuator having a recess penetrating the diaphragm on the partition wall arranged along at least a portion extending in the longitudinal direction of the slot, and a filler having a stress directed in a direction opposite to a stress generated in the diaphragm is filled in the recess.

### Fourth Aspect

In the piezoelectric actuator according to the second or third aspect, the stress of the filler has a smaller absolute value than the absolute value of the stress generated in the diaphragm.

### Fifth Aspect

In the piezoelectric actuator according to any one of the first to fourth aspects, the recess is a piezoelectric actuator disposed so as to surround the slot entirely.

### Sixth Aspect

In the piezoelectric actuator according to any one of the first to fifth aspects, the recess is disposed over a range wider than a width region in a longitudinal direction of the slot.

### Seventh Aspect

In the piezoelectric actuator according to any one of the first to sixth aspects, the width of the recess is equal to or less than half or less than the width of the partition wall.

### Eighth Aspect

In the piezoelectric actuator according to the second or third aspect, the diaphragm contains at least silicon oxide, and the filler is made of at least lead zirconate titanate.

### Ninth Aspect

A liquid discharge head includes a nozzle plate having a nozzle to discharge liquid, a liquid chamber communicating with the nozzle, and the piezoelectric actuator according to any one of the first to eighth aspects.

### Tenth Aspect

A liquid discharge apparatus includes the liquid discharge head according to the ninth aspect.

The above-described embodiments are illustrative and do not limit the present invention. Thus, numerous additional modifications and variations are possible in light of the above teachings. For example, elements and/or features of different illustrative embodiments may be combined with each other and/or substituted for each other within the scope of the present invention.

## Claims

1. A piezoelectric actuator (39) comprising:
a base (22) having:
a slot (41, 41a); and
a partition wall (48) partitioning the slot;
a diaphragm (33) bonded to the base in a bonding direction, the diaphragm having:
a first face on the partition wall and covering the slot;
a through hole (55) penetrating the diaphragm in the bonding direction,
the through hole (55) at a position opposed to the partition wall in a transverse direction intersecting the bonding direction, and
the through hole (55) extending along at least a portion of the slot in a longitudinal direction intersecting the bonding direction and the transverse direction; and
a piezoelectric element (40) on a second face of the diaphragm opposite the first face of the diaphragm.

2. The piezoelectric actuator (39) according to claim 1, further comprising a filler (56) filling the through hole (55),
wherein the diaphragm (33) has a first stress in a first direction, and
the filler has a second stress in a second direction opposite the first direction.

3. The piezoelectric actuator (39) according to claim 2,
wherein an absolute value of the second stress of the filler (56) is smaller than an absolute value of the first stress of the diaphragm.

4. The piezoelectric actuator (39) according to claim 1,
wherein the through hole (55) surrounds the slot (41a) in the longitudinal direction and the transverse direction.

5. The piezoelectric actuator (39) according to claim 1,
wherein the through hole (55) is longer than the slot (41a) in the longitudinal direction.

6. The piezoelectric actuator (39) according to claim 1,
wherein the through hole (55) has a width equal to or less than half of a width of the partition wall (48) in the transverse direction.

7. The piezoelectric actuator (39) according to claim 2,
wherein the diaphragm (33) contains at least silicon oxide, and
the filler (56) contains at least lead zirconate titanate.

8. A liquid discharge head (20) comprising:
the piezoelectric actuator (39) according to claim 1;
a liquid chamber (41) defined by the slot of the piezoelectric actuator (39); and
a nozzle plate (31) having a nozzle (30) communicating with the liquid chamber.

9. A liquid discharge apparatus (100) comprising the liquid discharge head (20) according to claim 8.

10. A piezoelectric actuator (39) comprising:
a base (22) having:
a slot (41, 41a); and
a partition wall (48) partitioning the slot;
a diaphragm (33) bonded to the base in a bonding direction, the diaphragm having:
a first face on the partition wall and covering the slot;
a recess (55a) at a position opposed to the partition wall in a transverse direction intersecting the bonding direction, and
the recess (55a) extending along at least a portion of the slot in a longitudinal direction intersecting the bonding direction and the transverse direction;
a piezoelectric element (40) on a second face of the diaphragm opposite the first face of the diaphragm; and
a filler (56) filling the recess (55a),
wherein the diaphragm (33) has a first stress in a first direction, and
the filler has a second stress in a second direction opposite the first direction.

11. The piezoelectric actuator (39) according to claim 10,
wherein the recess (55a) surrounds the slot (41a) in the longitudinal direction and the transverse direction.

12. The piezoelectric actuator (39) according to claim 10,
wherein the recess (55a) is longer than the slot (41a) in the longitudinal direction.

13. The piezoelectric actuator (39) according to claim 10,
wherein the recess (55a) has a width equal to or less than half of a width of the partition wall (48) in the transverse direction.

14. The piezoelectric actuator (39) according to claim 10,
wherein the diaphragm (33) contains at least silicon oxide, and
the filler (56) contains at least lead zirconate titanate.

15. A liquid discharge head (20) comprising:
the piezoelectric actuator (39) according to claim 10;
a liquid chamber (41) defined by the slot of the piezoelectric actuator (39); and
a nozzle plate (31) having a nozzle (30) communicating with the liquid chamber.

16. A liquid discharge apparatus (100) comprising the liquid discharge head (20) according to claim 15.
